# EUROPÄISCHE PATENTANMELDUNG

(11) **EP 4 546 143 A1**
(43) Veröffentlichungstag der Anmeldung: **30.04.2025**
(21) Anmeldenummer: 24207732.9
(22) Anmeldetag: 21.10.2024
(51) Int. Cl.: G06F 11/3698

(54) **VERFAHREN ZUR ÜBERPRÜFUNG VON FAHRZEUGFUNKTIONEN**

(30) Priorität: 25.10.2023 DE 102023129431
(71) Anmelder: VAIVA GmbH, 85080 Gaimersheim (DE)
(72) Erfinder: Haringer, Matthias, 86673 Bergheim (DE); Minow, Conrad, 85276 Pfaffenhofen a.d. Ilm (DE); Nentwig, Mirko, 85110 Kipfenberg (DE)
(74) Vertreter: Hofstetter, Schurack & Partner

(57) **Zusammenfassung**

Die Erfindung betrifft ein Verfahren zur Überprüfung von Fahrzeugfunktionen (5) für den Innenraum eines Fahrzeugs (7), wobei die Fahrzeugfunktionen (5) Sensordaten mindestens eines im Innenraum des Fahrzeugs (7) angeordneten Sensors (9) verarbeiten. Erfindungsgemäß ist vorgesehen, dass die Sensordaten des mindestens einen im Innenraum des Fahrzeugs (7) angeordneten Sensors (9) durch Simulation (2) des mindestens einen Sensors (9) unter Verwendung eines Umfeldmodells (11) zur virtuellen Typisierung des Außenbereichs des Fahrzeugs (7), eines Fahrzeugmodells (12) zur virtuellen Typisierung des Fahrzeugs (7), und eines Innenraummodells (14) zur virtuellen Typisierung des Innenbereichs des Fahrzeugs (7) generiert werden.

## Beschreibung

Die vorliegende Erfindung betrifft ein Verfahren zur Überprüfung von Fahrzeugfunktionen für den Innenraum eines Fahrzeugs gemäß dem Oberbegriff des Patentanspruchs 1.

Die DE 10 2015 016 511 A1 beschreibt ein Verfahren zum Erstellen einer Datenstruktur zur Einstellung wenigstens eines Fahrzeugsystems eines Kraftfahrzeugs, insbesondere eines Sicherheitssystems eines Kraftfahrzeugs. Bei diesem Verfahren wird ein parametrierbares, biomechanisches Menschmodell verwendet, das in Abhängigkeit von Insasseneigenschaften eines Insassen des Kraftfahrzeugs beschreibenden Modellparametern gewonnen wird. Als Insasseneigenschaften für die Modellparameter werden beispielsweise Geschlecht, Größe, Gewicht, Gewichtsverteilung, Körperbau, Skelettgeometrie, Skelettkonstitution und medizinische Vorschädigungen herangezogen. Für das Kraftfahrzeug werden Simulationen für mehrere Modellparametersätze dieser Modellparameter und mehrere jeweils einen Unfall beschreibende Unfalldatensätze durchgeführt. Für jeweils einen Modellparametersatz wird hieraus ein Sicherheitswert als Maß für die Sicherheit des durch das Menschmodell beschriebenen Insassen ermittelt. Für das wenigstens eine Fahrzeugsystem werden anhand dieser Sicherheitswerte optimierte Fahrzeugsystemparameter ermittelt und diese zur Erstellung der Datenstruktur verwendet. Hierdurch kann im Kraftfahrzeug eine individuelle Abstimmung der Fahrzeugsysteme und insbesondere der Sicherheitssysteme des Kraftfahrzeugs auf die spezifischen anatomischen und medizinischen Eigenheiten eines Insassen des Kraftfahrzeugs vorgenommen werden.

Weiterhin ist aus der US 11,148,671 B2 ein Verfahren zur Generierung und Übermittlung von Informationen eines sich in einer virtuellen (Fahrzeug-)Umgebung bewegenden virtuellen Person (eines sogenannten Avatars) als Stellvertreter einer sich außerhalb des Fahrzeugs befindlichen (echten) Person bekannt. Für diese echte beziehungsweise natürliche Person sollen bestimmte Situationen des Fahrzeugs und Funktionalitäten von Fahrzeugsystemen des Fahrzeugs stellvertretend durch den Avatar kontrolliert erlebt beziehungsweise ausgeführt werden, insbesondere um den echten (natürlichen) Personen negative Gefühle wie Unsicherheit, Sorge, Stress oder Angst bei der Bedienung von neuen und unbekannten Fahrzeugsystemen zu nehmen, wie beispielsweise den autonomen Fahrbetrieb des Fahrzeugs. Hierbei wird das Verhalten der echten (natürlichen) Person mittels Sensorsystemen überwacht und abhängig hiervon die virtuelle Umgebung des Fahrzeugs beeinflusst.

In der US 11,294,796 B2 ist ein Verfahren zur Entwicklung von Anwendungssystemen eines Fahrzeugs beschrieben, bei dem einem Entwickler eine Simulationsumgebung für das Fahrzeug bereitgestellt wird. In dieser Simulationsumgebung kann der Entwickler gewünschte Fahrzeugparameter testweise vorgeben, beispielsweise die Lüfterdrehzahl oder die Fahrzeuggeschwindigkeit, und die hierauf erfolgende Reaktion des simulierten Fahrzeugs beobachten und auswerten.

In der US 11,379,705 B2 ist ein Verfahren zur Simulation einer menschenähnlichen Entscheidung in einer Simulationsumgebung beschrieben, bei dem insbesondere mittels Sensoren erfasste hochdimensionale Daten des Umfelds in eine niederdimensionale Umgebung komprimiert werden. Die komprimierten Daten in der niederdimensionalen Umgebung werden nach verschiedenen Kriterien bewertet und können bei einer in der Simulationsumgebung getroffenen menschenähnlichen Entscheidung dann gegebenenfalls ergänzt werden, um der getroffenen Entscheidung zu entsprechen.

Schließlich ist in der US 2020/0377081 A1 ein Verfahren zur Simulation der Fahrzeugsicherheit eines Fahrzeugs unter Verwendung von Crashinformationen aus simulierten Aufprallereignissen unter Einbeziehung real gewonnener Daten offenbart. Als Parameter werden insbesondere Positionen, Ausrichtungen und Geschwindigkeiten der am Crash beteiligten Fahrzeuge und Positionen der Insassen des Fahrzeugs herangezogen. Hieraus soll insbesondere die Leistungsfähigkeit eines Sicherheitssystems des Fahrzeugs mit einer Kombination aus einer Kollisionsvermeidungsfunktion und einer Verletzungspräventionsfunktion quantifiziert werden.

Es ist Aufgabe der vorliegenden Erfindung, ein Verfahren zur Überprüfung von Fahrzeugfunktionen für den Innenraum eines Fahrzeugs mit vorteilhaften Eigenschaften bezüglich der für die Fahrzeugfunktion bereitgestellten simulierten Daten anzugeben.

Zur Lösung dieser Aufgabe dient ein gattungsgemäßes Verfahren mit den Merkmalen des Patentanspruchs 1.

Vorteilhafte Ausgestaltungen des Verfahrens sind in den weiteren Patentansprüchen beschrieben.

Erfindungsgemäß wird ein Verfahren zur Überprüfung von Fahrzeugfunktionen für den Innenraum eines Fahrzeugs vorgestellt, bei dem eine gesamtheitliche Betrachtung der Anwendung einer 3D-Computersimulation für die Überprüfung dieser Fahrzeugfunktionen unter Einbeziehung der Fahrzeuginsassen des Fahrzeugs und deren Reaktionen erfolgt.

Unter dem Begriff Fahrzeugfunktionen sind insbesondere auch Fahrzeugsysteme zu verstehen, das heißt solche Systeme des Fahrzeugs, die bestimmte Funktionalitäten des Fahrzeugs durchführen oder ausführen. Unter dem Begriff Überprüfung von Fahrzeugfunktionen ist insbesondere auch das Testen derartiger Fahrzeugfunktionen zu verstehen, das heißt auch die Beaufschlagung derartiger Fahrzeugfunktionen mit einem bestimmten Testverfahren oder Testprocedere.

Beim erfindungsgemäßen Verfahren zur Überprüfung von Fahrzeugfunktionen wird eine hochgenaue Simulation der Fahrzeuginsassen und ihrer Bewegungen, des Fahrzeuginnenraums und des Umfelds des Fahrzeugs und deren Wechselwirkungen zur Erzeugung der Sensordaten mindestens eines im Innenraum des Fahrzeugs angeordneten simulierten Sensors vorgenommen. Hierbei können unterschiedliche sensorbasierte Fahrzeugfunktionen für den Innenraum eines Fahrzeugs durch eine gesamtheitliche Simulation der Daten mindestens eines im Innenraum des Fahrzeugs angeordneten Sensors umfassend überprüft werden. Insbesondere kommen als derartige Fahrzeugfunktionen Absicherungsfunktionen in Betracht, insbesondere Absicherungssysteme, beispielsweise zur Absicherung von Innenraumverhältnissen im Fahrzeug, zur Absicherung von Insassen im Fahrzeug oder zur Absicherung von Airbagfunktionen, insbesondere von Airbagsystemen, beispielsweise zur Warnung bei Airbag kompromittierenden Situationen oder zur Unterdrückung von Airbagauslösungen des Fahrzeugs. Weiterhin kommen als derartige Fahrzeugfunktionen aber auch alle Sensordaten verarbeitenden Fahrzeugsysteme in Betracht, wie zum Beispiel Assistenzsysteme für das fahrerlose Fahren des Fahrzeugs oder Assistenzsysteme für das fahrerlose Parken des Fahrzeugs, integrale Sicherheitssysteme des Fahrzeugs oder Fahrzeugsysteme zur Fahrerüberwachung und/oder zur Insassenüberwachung. Die Fahrzeugfunktionen und Fahrzeugsysteme können hierbei bei beliebigen Fahrzeugen zum Einsatz kommen, beispielsweise bei Personenkraftwagen, Lastkraftwagen, Bussen, Bahnen oder Flugzeugen.

Bei der Durchführung der Simulation der Daten für mindestens einen im Innenraum des Fahrzeugs angeordneten Sensor, die von den zu überprüfenden Fahrzeugfunktionen und insbesondere von den zu überprüfenden Fahrzugsystemen für den Innenraum eines Fahrzeugs verarbeitet werden, werden als Eingangsgrößen für die Simulation bestimmte Modellwerte eines Umfeldmodells mit der virtuellen Typisierung des Außenbereichs des Fahrzeugs, bestimmte Modellwerte eines Fahrzeugmodells mit der virtuellen Typisierung des Fahrzeugs, und bestimmte Modellwerte eines Innenraummodells mit der virtuellen Typisierung des Innenbereichs des Fahrzeugs herangezogen. Für die Simulation werden somit diejenigen die Verhältnisse im Innenraum des Fahrzeugs direkt beeinflussenden Einflussgrößen des Innenraummodells und auch die die Verhältnisse im Innenraum des Fahrzeugs indirekt beeinflussenden Einflussgrößen des Umfeldmodells und des ein neutrales Fahrzeug mit allen Interieurbauteilen und elektronischen Mensch-Maschine-Schnittstellen-Komponenten beschreibenden Fahrzeugmodells herangezogen. Das heißt, die Simulation erfolgt insbesondere auch unter expliziter und impliziter Berücksichtigung der Verhältnisse im Innenraum des Fahrzeugs und in der Umgebung des Fahrzeugs.

Das Innenraummodell zur expliziten und direkten Berücksichtigung des Fahrzeuginnenraums und damit zur virtuellen Typisierung des Innenbereichs des Fahrzeugs, beinhaltet insbesondere insassenbezogene Parameter für mindestens einen Fahrzeuginsassen und handlungsbezogene Parameter für mindestens einen Fahrzeuginsassen und/oder sensorbezogene Parameter für mindestens einen Sensor im Innenraum des Fahrzeugs, vorzugsweise sensorbezogene Parameter für mehrere Sensoren im Innenraum des Fahrzeugs.

In einer vorteilhaften Weiterbildung des Verfahrens werden als für mindestens einen Fahrzeuginsassen herangezogene insassenbezogene Parameter des Innenraummodells bestimmte die Fahrzeugsitze charakterisierende Kenngrößen herangezogen, die den jeweiligen Fahrzeuginsassen zugeordnet sind und die insbesondere angeben, welcher Fahrzeuginsasse auf welchem Fahrzeugsitz platziert ist und in welcher Sitzposition der jeweilige Fahrzeuginsasse auf dem jeweiligen Fahrzeugsitz platziert ist. Beispielsweise, ob der jeweilige Fahrzeuginsasse in einer aufrechten Haltung oder in einer geneigten Haltung oder in einer liegenden Haltung auf dem Fahrersitz oder auf dem Beifahrersitz oder auf der Rücksitzbank des Fahrzeugs platziert ist.

Zusätzlich oder alternativ hierzu können als insassenbezogene Parameter des Innenraummodells auch den Insassentyp der jeweiligen Fahrzeuginsassen charakterisierende Kenngrößen herangezogen werden. Durch Wahl von Geschlecht, Ethnie, Körpergröße, Gewicht etc. der jeweiligen Fahrzeuginsassen können hierdurch standardisierte Fahrzeuginsassen definiert und vorgegeben werden oder Fahrzeuginsassen, die bestimmte Normwerte erfüllen, definiert und vorgegeben werden oder aber beliebige Fahrzeuginsassen mit frei wählbaren und anpassbaren Eigenschaften definiert und vorgegeben werden.

Zusätzlich oder alternativ hierzu können als insassenbezogene Parameter des Innenraummodells auch die Ausstattung der jeweiligen Fahrzeuginsassen charakterisierende Kenngrößen herangezogen werden. Durch Wahl von Kleidung, Kopfbedeckung, Haarfarbe, Frisur etc. der jeweiligen Fahrzeuginsassen können hierdurch beispielsweise Effekte der Beschattung oder der Bedeckung oder der Verhüllung durch Tücher, Hüte etc. berücksichtigt werden. Beschattung und Bedeckung meint hierbei eine Einschränkung der Erkennbarkeit der Körperhaltung der Fahrzeuginsassen in Bezug auf einen beliebigen nicht unbedingt optischen Sensor.

In einer weiteren vorteilhaften Weiterbildung des Verfahrens werden als für mindestens einen Fahrzeuginsassen herangezogene handlungsbezogene Parameter des Innenraummodells bestimmte die Körperhaltung der jeweiligen Fahrzeuginsassen charakterisierende Kenngrößen als Posen der jeweiligen Fahrzeuginsassen herangezogen. Diese, die Körperhaltung der jeweiligen Fahrzeuginsassen betreffenden Posen, können beliebig und je nach zu überprüfender Fahrzeugfunktion beziehungsweise je nach Anwendungsfall vorgegeben werden und hierzu im Rahmen einer Animation als animierte Posen erstellt werden oder aber mittels Aufnahmen als Bewegungserfassung echter Personen im Rahmen eines Trackingverfahrens ("motion capturing") zur Erfassung und Aufzeichnung von Bewegungen generiert werden. Hierbei können einfache Posen der jeweiligen Fahrzeuginsassen vorgegeben werden, wie beispielsweise ein Umschauen der jeweiligen Fahrzeuginsassen, ein aus dem Fenster schauen der jeweiligen Fahrzeuginsassen, ein Anlehnen an die Seitentüre durch die jeweiligen Fahrzeuginsassen, ein Anlehnen an ein Seitenfenster durch die jeweiligen Fahrzeuginsassen etc.. Daneben können die Posen der jeweiligen Fahrzeuginsassen auch mit verschiedenen Fußpositionen der jeweiligen Fahrzeuginsassen und verschiedenen Körperhaltungen der jeweiligen Fahrzeuginsassen und auch mit verschiedenen Sitzpositionen der jeweiligen Fahrzeuginsassen verknüpft werden, beispielsweise die Einnahme einer zumindest teilweise liegenden Position der jeweiligen Fahrzeuginsassen auf einem Fahrzeugsitz, was für bestimmte sicherheitsrelevante Fahrzeugfunktionen und Fahrzeugsysteme und Fahrfunktionen betreffende Fahrsysteme oder für Airbagfunktionen und Airbagsysteme abgeprüft werden muss. Weiterhin können bestimmte Posen der jeweiligen Fahrzeuginsassen auch mit Gegenständen verknüpft werden, das heißt die Handhabung dieser Gegenstände durch die jeweiligen Fahrzeuginsassen mit bestimmten Posen belegt werden.

Zusätzlich oder alternativ hierzu können als handlungsbezogene Parameter des Innenraummodells auch bestimmte Aktionen der jeweiligen Fahrzeuginsassen charakterisierende Kenngrößen herangezogen werden. Diese Aktionen der jeweiligen Fahrzeuginsassen können Gegenstände des Fahrzeugs oder sonstige Gegenstände im Innenraum des Fahrzeugs betreffen, wie beispielsweise das Bedienen von Bedienelementen des Fahrzeugs oder das Telefonieren mit einem Mobiltelefon oder das Rauchen von Tabakwaren oder den Verzehr von Lebensmitteln oder die Lektüre in einem Buch oder die Benutzung eines Laptops, Tablets oder einer VR/AR/MR-Brille.

In einer weiteren vorteilhaften Weiterbildung des Verfahrens werden als sensorbezogene Parameter des Innenraummodells die Art der jeweiligen Sensoren je nach zu überprüfender Fahrzeugfunktion beziehungsweise je nach Anwendungsfall vorgegeben. Hierbei können beliebige Arten von Sensoren für den Innenraum des Fahrzeugs ausgewählt werden, beispielsweise nicht-bildgebende Sensoren wie Sitzbelegungssensoren und Gurtauszugssensoren oder Radarsensoren, die beispielsweise zur Kindererkennung in einem Kindersitz eingesetzt werden können, oder bildgebende Sensoren wie beispielsweise LiDAR-Sensoren und insbesondere auch optische Sensoren im sichtbaren Bereich oder Infrarotbereich wie Kameras etc. Insbesondere können hierbei mehrere derartige Sensoren oder mehrere Sensorarten oder Sensorsysteme gleichzeitig ausgewählt und für die Simulation herangezogen werden.

Zusätzlich oder alternativ hierzu können als sensorbezogene Parameter des Innenraummodells auch die Anordnung der jeweiligen Sensoren im Innenraum des Fahrzeugs je nach Anwendungsfall und in Abhängigkeit der zu überprüfenden Fahrzeugfunktion vorgegeben werden. Hierbei kann insbesondere auch die Anzahl und die Positionierung der Sensoren im Innenraum des Fahrzeugs gewählt werden, das heißt, welche Bereiche oder Gegenstände oder Bauteile oder Komponenten im Innenraum des Fahrzeugs vom jeweiligen Sensor und/oder von den jeweiligen Sensoren detektiert beziehungsweise beobachtet werden sollen oder welche der jeweiligen Fahrzeuginsassen vom jeweiligen Sensor oder von den jeweiligen Sensoren beobachtet werden sollen etc. Dies kann auch in einer frühen Konzeptphase des Fahrzeugs erfolgen, um die noch nicht spezifizierten Sensorpositionen beliebiger wahrnehmender Sensoren zu ermitteln.

Zusätzlich oder alternativ hierzu können als sensorbezogene Parameter des Innenraummodells auch die Eigenschaften der jeweiligen Sensoren im Innenraum des Fahrzeugs je nach Anwendungsfall und in Abhängigkeit der zu überprüfenden Fahrzeugfunktion vorgegeben werden. Hierbei können beispielsweise das Rauschverhalten, das Abbildungsverhalten, die Verzerrungseigenschaften etc. der jeweiligen zu simulierenden Sensoren im Innenraum des Fahrzeugs derart angepasst werden, dass deren Eigenschaften denen der realen Bauteile und Komponenten im Innenraum des Fahrzeugs entsprechen, so dass auch die simulierten Ausgabewerte der Sensoren möglichst denen der realen Sensoren im Innenraum des Fahrzeugs entsprechen. Das heißt, es werden durch die Simulation Sensordaten der Sensoren in der Qualitätsstufe erzeugt, wie diese auch echte Sensoren liefern würden. Bei einer Abweichung können dann die zur Simulation verwendeten Simulationsmodelle und deren Parameter angepasst werden, bis eine geforderte beziehungsweise gewünschte Übereinstimmung zwischen den Sensordaten der simulierten Sensoren und denen der realen Sensoren vorliegt.

Wie bereits erwähnt, können in einer weiteren vorteilhaften Weiterbildung des Verfahrens zur Überprüfung von Fahrzeugfunktionen eines Fahrzeugs und insbesondere von Fahrzeugsystemen des Fahrzeugs, die Sensordaten gleichzeitig für mehrere Sensoren im Innenraum des Fahrzeugs in Echtzeit durch simultane Simulation dieser Sensoren generiert werden. Diese Multisensorfähigkeit beinhaltet somit die gleichzeitige Platzierung und den gleichzeitigen Input von unterschiedlichen Sensoren oder Sensorsystemen und auch die simultane Simulation unterschiedlicher Sensoren oder Sensorsysteme in Echtzeit und die Erstellung beziehungsweise die Ausgabe von Ausgabewerten oder Sensorsignalen als Sensordaten der Sensoren oder der Sensorsysteme in Echtzeit.

Insgesamt werden die genannten Parameter des Innenraummodells je nach Anwendungsfall der Simulation und der zu überprüfenden Fahrzeugfunktion und damit in Abhängigkeit des hierzu verwendeten Rechenalgorithmus für den jeweiligen Anwendungsfall unterschiedlich und an die zu überprüfende Fahrzeugfunktion angepasst gewählt.

Vorzugsweise werden für die zu überprüfende Fahrzeugfunktion eine Anzahl von ausgewählten Testfällen vorgegeben, bei denen unterschiedliche Vorgabewerte für die insassenbezogenen Parameter des Innenraummodells und/oder für die handlungsbezogenen Parameter des Innenraummodells und/oder für die sensorbezogenen Parameter des Innenraummodells gewählt werden. Das heißt, die Simulation zur Generierung der Sensordaten des jeweiligen im Innenraum des Fahrzeugs angeordneten Sensors, erfolgt mit jeweils unterschiedlichen Werten für die insassenbezogenen Parameter des Innenraummodells und/oder für die handlungsbezogenen Parameter des Innenraummodells und/oder für die sensorbezogenen Parameter des Innenraummodells. Als Testfälle können hierbei standardmäßig vorgegebene Szenarien herangezogen werden oder durch die jeweilige Anwendung bedingte individuelle an den jeweiligen Anwendungsfall angepasste Szenarien.

Bei bestimmten Fahrzeugfunktionen und zu überprüfenden Fahrzeugsystemen, wie insbesondere bei einem System zur Insassenabsicherung, kann hierbei insbesondere eine Anzahl von Testfällen mit einer jeweiligen Einordnung als Gutfälle und Schlechtfälle vorgegeben werden. Die Simulation zur Generierung der Sensordaten des jeweiligen im Innenraum des Fahrzeugs angeordneten Sensors wird dann für eine Vielzahl von Grenzfällen im Grenzbereich zwischen den Gutfällen und den Schlechtfällen durchgeführt. Das heißt, die zu überprüfende Fahrzeugfunktion wird bei einer Vielzahl von Grenzfällen in dem Grenzbereich abgeprüft. Beispielsweise soll bei einer Absicherungsfunktion als zu überprüfende Fahrzeugfunktion die Seitenneigung der Fahrzeuginsassen einen Winkel von 45° nicht überschreiten, wobei dann die Auswirkungen einer Winkeländerung in diesem Grenzbereich von 45° auf die Fahrzeugfunktion bei einer Vielzahl von Testfällen durch die Simulation abgeprüft wird. Als weiteres Beispiel einer Absicherungsfunktion als zu überprüfende Fahrzeugfunktion muss beispielsweise mit einer Sicherheit von 95% erkannt werden, ob sich im Innenraum des Fahrzeugs ein mobiles Gerät zwischen einem Fahrzeuginsassen und dem Airbag des Fahrzeugs befindet, da die Auslösung des Airbags abhängig von Vorhandensein eines derartigen Gegenstands gesteuert wird.

Zusätzlich können für die Fahrzeuginsassen auch durch Simulation mit der Finite-Elemente-Methode oder ähnlich genauen Methoden erstellte Menschmodelle zur Erhöhung der Präzision der Simulation im normalen Fahrbetrieb beziehungsweise Fahrmodus des Fahrzeugs herangezogen werden. Diese Menschmodelle können die Anatomie und den Aufbau eines Fahrzeuginsassen mit einer gewünschten oder erforderlichen Genauigkeit nachbilden. Beispielsweise können hierbei bei einem detaillierten Menschmodell auch Gewichtsverhältnisse, Muskelstränge oder ähnliche Details berücksichtigt werden.

Zu der Erfindung gehört auch eine Simulationsvorrichtung, die dazu eingerichtet ist, eine jeweilige Ausführungsform des erfindungsgemäßen Verfahrens durchzuführen.

Die Simulationsvorrichtung kann eine Datenverarbeitungsvorrichtung oder eine Prozessoreinrichtung aufweisen oder als Datenverarbeitungsvorrichtung oder als Prozessoreinrichtung ausgebildet sein. Die Prozessoreinrichtung kann hierzu zumindest einen Mikroprozessor und/oder zumindest einen Mikrocontroller und/oder zumindest ein FPGA (Field Programmable Gate Array) und/oder zumindest einen DSP (Digital Signal Processor) aufweisen. Als Mikroprozessor kann insbesondere jeweils eine CPU (Central Processing Unit), eine GPU (Graphical Processing Unit) oder eine NPU (Neural Processing Unit) verwendet werden. Des Weiteren kann auch die Prozessoreinrichtung einen Programmcode aufweisen, der dazu eingerichtet ist, bei Ausführung durch die Prozessoreinrichtung die Ausführung eines der beschriebenen Erfindungsmerkmale vorzunehmen. Der Programmcode kann in einem Datenspeicher der Prozessoreinrichtung gespeichert sein. Die Prozessoreinrichtung kann beispielsweise auf zumindest einer Schaltungsplatine und/oder auf zumindest einem SoC (System on Chip) integriert sein.

Insbesondere kann die Simulation in einer hardware in the loop (HIL) Simulationsvorrichtung mit einer Anbindung an reale Hardwarekomponenten wie beispielsweise Steuergeräte des Fahrzeugs vorgenommen werden oder als software in the loop (SIL) Simulation ohne eine derartige Anbindung an reale Steuergeräte des Fahrzeugs vorgenommen werden.

Vorteilhafterweise kann mit dem erfindungsgemäßen Verfahren eine umfassende Überprüfung bestimmter Fahrzeugfunktionen und insbesondere Fahrzeugsysteme und deren Anwendungsfälle durch eine Simulation des Innenraums des Fahrzeugs unter Berücksichtigung der sich im Innenraum des Fahrzeugs befindlichen Sensoren und der Fahrzeuginsassen des Fahrzeugs in Echtzeit mit hoher Sensorqualität vorgenommen werden und mit 3D-Echtzeitgrafikmethoden visualisiert werden. Hierzu wird vorzugsweise ein Satz von an beliebigen Positionen im Innenraum des Fahrzeugs angeordneten (bekannten) beliebigen Sensoren herangezogen, für die simultan durch Simulation Sensordaten erzeugt werden und Inhalte für Algorithmen generiert werden. Das heißt, die unterschiedlichen Sensoren werden synchron in Echtzeit simuliert. Durch das Innenraummodell des erfindungsgemäßen Verfahrens wird der Innenraum des Fahrzeugs exakt animationsgetreu und sensorgetreu abgebildet.

Weitere Vorteile, Merkmale und Einzelheiten der Erfindung ergeben sich aus der nachfolgenden Beschreibung bevorzugter Ausführungsbeispiele sowie anhand der Zeichnung.

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar ohne den Rahmen der Erfindung zu verlassen.

Dabei zeigen:
- Fig. 1: in einer schematischen Darstellung die Wirkkette für die Simulation mit dem erfindungsgemäßen Verfahren und
- Fig. 2: in einer schematischen Darstellung den zeitlichen Ablauf für die Konfiguration und Simulation mit dem erfindungsgemäßen Verfahren.

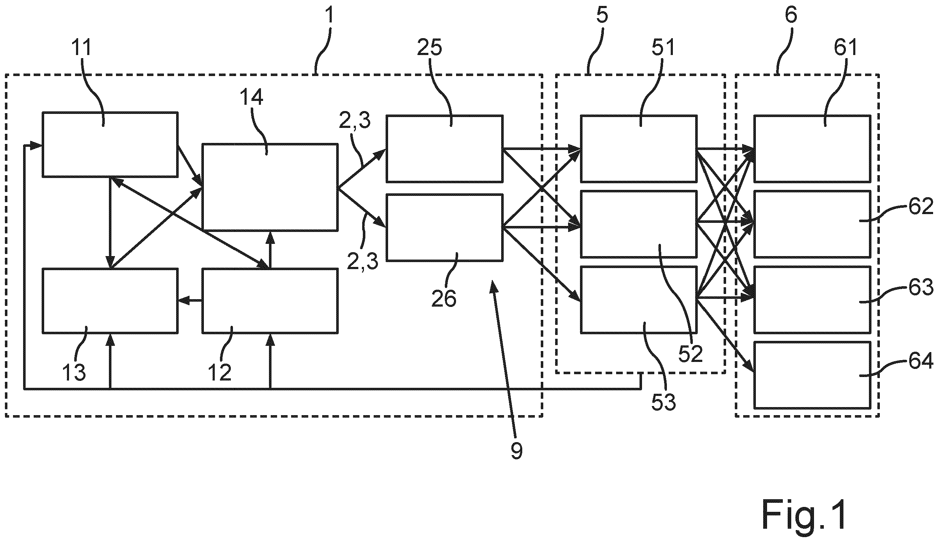

Gemäß der in der Figur 1 dargestellten Wirkkette für das erfindungsgemäße Verfahren stellt die Simulationsumgebung 1 die Eingangsgrößen für die als Fahrzeugfunktionen herangezogenen Fahrzeugsysteme 5 bereit, denen wiederum bestimmte Anwendungsfälle 6 zugeordnet sind.

Als Eingangsgrößen für die als Fahrzeugfunktionen 5 herangezogenen Fahrzeugsysteme werden in der Regel Sensorsignale von Sensoren 9 herangezogen, beispielsweise die Sensorsignale von bildgebenden Sensoren 25 wie optischen Kameras, Tiefenkameras, Radargeräten oder Ultraschallsensoren oder von Statussensoren 26 oder von Wegesensoren 26 wie Gurtauszugssensoren, Gewichtssensoren oder kapazitiven Sensoren zur Sitzbelegungserkennung etc., und/oder als Eingangsgrößen für die als Fahrzeugfunktionen 5 herangezogenen Fahrzeugsysteme werden die Signale von Bussystemen des Fahrzeugs oder sonstige funktionale Signale des Fahrzeugs herangezogen.

In der Simulationsumgebung 1 werden verschiedene Simulationsmodelle 11, 12, 13, 14 zur Durchführung der Simulation 2 bereitgestellt, die abhängig von dem jeweils gewählten Fahrzeugsystem als Fahrzeugfunktion 5 und/oder abhängig von dem jeweiligen Anwendungsfall 6 entsprechend angepasst werden können.

Für das Umfeldmodell 11 der Simulationsumgebung 1 werden Testumgebungen in einer von dem jeweils gewählten Fahrzeugsystem als Fahrzeugfunktion 5 abhängigen Güte und/oder in einer vom jeweiligen Anwendungsfall 6 abhängigen Güte generiert, das heißt, die dargestellten und simulierten Bestandteile des Umfelds und deren Detaillierungsgrad werden je nach dem jeweils gewählten Fahrzeugsystem als Fahrzeugfunktion 5 und Anwendungsfall 6 unterschiedlich vorgegeben.

Für das Fahrzeugmodell 12 der Simulationsumgebung 1 wird eine Fahrzeugauswahl aus der von einem Fahrzeughersteller bereitgestellten Variantenliste getroffen. Für das ausgewählte Fahrzeug wird dann eine Anpassung hinsichtlich möglicher Ausstattungsvarianten vorgenommen, insbesondere für solche Ausstattungsmerkmale, die von einem jeweiligen Sensor 9 im Innenraum des Fahrzeugs wahrgenommen beziehungsweise detektiert werden können.

Für das Fahrermodell 13 der Simulationsumgebung 1 wird ein bestimmtes Verhalten des Fahrers ausgewählt, das dann eine entsprechende Auswirkung auf die Fahrzeuginsassen und damit auf den Innenraum des Fahrzeugs mit sich bringt. Das heißt, das Fahrermodell 13 beinhaltet all diejenigen Kriterien eines virtuellen Fahrers, die einen Einfluss auf das Verhalten der Fahrzeuginsassen und damit auf den Innenraum des Fahrzeugs bewirken. Beispielsweise genannt seien hierzu der Fahrstil des Fahrers oder das Fahrverhalten des Fahrers oder die Fahrercharakterisierung des Fahrers hinsichtlich des Fahrertyps.

Für das Innenraummodell 14 der Simulationsumgebung 1 werden für einen Fahrzeuginsassen des Fahrzeugs dessen Eigenschaften und Verhaltensweisen oder für mehrere Fahrzeuginsassen des Fahrzeugs deren Eigenschaften und Verhaltensweisen vorgegeben und ebenso die Eigenschaften und Funktionalitäten von im Innenraum des Fahrzeugs angeordneten Sensoren 9.

Die anhand der Vorgabewerte aus diesen Simulationsmodellen 11, 12, 13, 14 der Simulationsumgebung 1 durchgeführte Simulation 2 liefert bestimmte Ausgabewerte für die zu überprüfenden Fahrzeugsysteme als Fahrzeugfunktionen 5. Diese Fahrzeugsysteme als Fahrzeugfunktionen 5 können beispielsweise Beobachtungssysteme 51 zur Beobachtung bestimmter Aktionen und Reaktionen des Fahrers im Innenraum des Fahrzeugs sein oder Beobachtungssysteme 52 zur Beobachtung bestimmter Aktionen und Reaktionen der Fahrzeuginsassen im Innenraum des Fahrzeugs oder zur Beobachtung der Auswirkungen von bestimmten Vorgaben auf die Fahrzeuginsassen im Innenraum des Fahrzeugs ausgebildet sein oder als Absicherungssysteme 53 zur Absicherung bestimmter Problemfälle beziehungsweise unzulässiger Szenarien hinsichtlich des Verhaltens der Fahrzeuginsassen im Innenraum des Fahrzeugs ausgebildet sein.

In Abhängigkeit der Simulationsergebnisse für diese Fahrzeugsysteme als Fahrzeugfunktion 5 erfolgt gegebenenfalls auch eine Rückwirkung in Echtzeit auf die Simulationsumgebung 1 mit den darin enthaltenen Simulationsmodellen 11, 12, 13, 14, die dann entsprechend angepasst und damit präzisiert beziehungsweise verfeinert werden können.

Als Anwendungsfälle 6 (oder auch "use cases") der Fahrzeugsysteme als Fahrzeugfunktionen 5 kommen unterschiedliche Kategorien in Betracht. Exemplarisch genannt seien hierzu der Anwendungsfall 61 hinsichtlich der Verhinderung von bestimmten unzulässigen Szenarien oder der Warnung bei bestimmten unzulässigen Szenarien, der Anwendungsfall 62 hinsichtlich der Absicherung beim Auftreten von bestimmten problematischen Szenarien, der Anwendungsfall 63 hinsichtlich der Entwicklung und/oder der Optimierung und/oder des Tests bestimmter Fahrzeugsysteme als Fahrzeugfunktionen 5 oder Sensoren 9. Weiterhin können im Anwendungsfall 63 die Ergebnisse der Simulationsumgebung 1 für die Positionierung und Auslegung der Sensoren 9 zu einem frühen Entwicklungsstadium im Rahmen der Entwicklung eines Fahrzeugs herangezogen werden. Im Anwendungsfall 64 kann die Sichtbarkeit von Verkehrsteilnehmern, Bedienelementen und Anzeigeelementen für das Sichtfeld des Fahrers oder eines Fahrzeuginsassen durch die Simulation vor dem Bau eines Fahrzeugs geprüft werden.

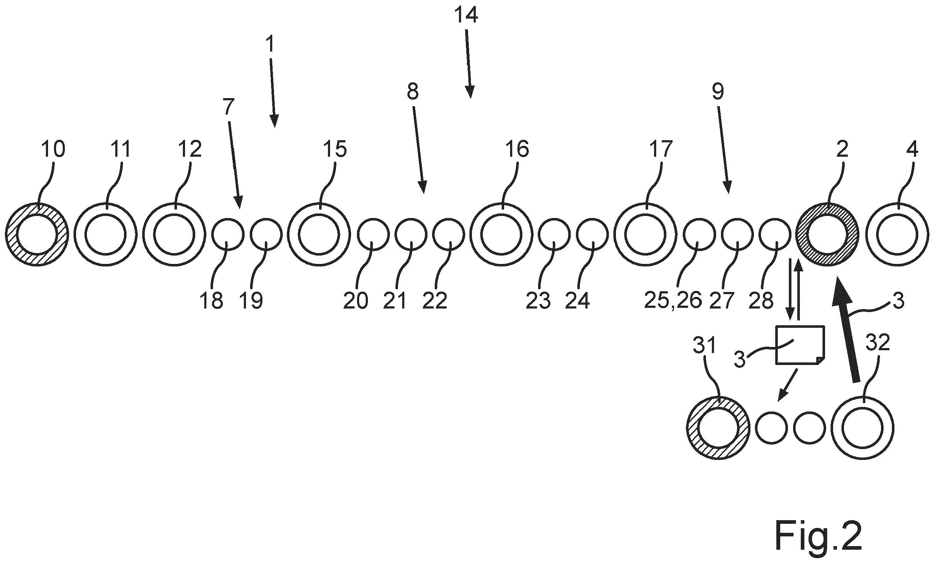

Gemäß der Figur 2 gestaltet sich der zeitliche Ablauf der Simulation bei der Überprüfung einer Fahrzeugfunktion 5 des Fahrzeugs 7 für einen bestimmten Anwendungsfall 6 wie folgt:
Beim Start 10 des Verfahrens werden nach dem Laden des Simulationsprogramms bestimmte Testfälle 3 generiert und entsprechend konfiguriert. Die Generierung und Konfigurierung der Testfälle 3 erfolgt vorzugsweise über eine Grafische Benutzeroberfläche (GUI) oder über einen ausführbaren Datenfile ("configfile"), bei dem eine bestimmte Anzahl von vorher konfigurierten Testfällen 3 automatisiert ablaufen kann.

Bei der Auswahl und Vorgabe der virtuellen Umwelt des Fahrzeugs 7 im Rahmen des Umfeldmodells 11 der Simulationsumgebung 1 beinhaltet die Testumgebung des Umfeldmodells 11 all diejenigen Kriterien, die einen Einfluss auf den Innenraum des Fahrzeugs 7 bewirken. Beispielsweise die für die Simulation 2 ausgewählte Straße oder der Straßentyp, Straßenmarkierungen, Verkehrsobjekte und Verkehrszeichen in der Umgebung des Fahrzeugs 7, die das Fahrzeug 7 umgebende Landschaft, Gebäude in der Umgebung des Fahrzeugs 7, die Tageszeit, die Lichtverhältnisse hinsichtlich Helligkeit oder Dunkelheit etc.

Bei der Auswahl und Vorgabe des virtuellen Fahrzeugs 7 im Rahmen des Fahrzeugmodells 12 der Simulationsumgebung 1 erfolgt zunächst eine Auswahl 18 des Modelltyps des Fahrzeugs 7 und anschließend eine Anpassung 19 derjenigen Kriterien des Fahrzeugs 7, die einen Einfluss auf den Innenraum des Fahrzeugs 7 haben. Hierbei wird sowohl der Außenbereich (das Exterieur) des Fahrzeugs 7 mit vorgegebenen Varianten des Fahrzeugherstellers angepasst, als auch der Innenbereich (das Interieur) des Fahrzeugs 7 mit vorgegebenen Varianten des Fahrzeugherstellers angepasst, beispielsweise hinsichtlich der Materialbeschaffenheit von Interieurbauteilen des Fahrzeugs 7 oder der Innenraumverkleidung des Fahrzeugs 7.

Bei der Auswahl und Vorgabe des virtuellen Innenraums des Fahrzeugs 7 im Rahmen des Innenraummodells 14 der Simulationsumgebung 1 werden zunächst insassenbezogene Parameter 15 ausgewählt beziehungsweise variabel vorgegeben. Hierbei wird für die Fahrzeugsitze 20 die Anzahl der Fahrzeugsitze 20 und die Verstellbarkeit der Fahrzeugsitze 20 ausgewählt und vorgegeben. Diesen Fahrzeugsitzen 20 werden dann eine vorgegebene Anzahl an Fahrzeuginsassen 8 und deren jeweilige Position zugeordnet, das heißt, an welcher Position im Fahrzeug soll ein Fahrzeuginsasse 8 platziert werden, beispielsweise auf dem Fahrersitz des Fahrzeugs und/oder auf dem Beifahrersitz des Fahrzeugs und/oder auf der Rücksitzbank des Fahrzeugs. Weiterhin erfolgt neben der Vorgabe der Anzahl der jeweiligen Fahrzeuginsassen 8 auch eine Vorgabe des Insassentyps 21 des jeweiligen Fahrzeuginsassen 8, insbesondere dahingehend, ob für den jeweiligen Fahrzeuginsassen 8 als Insassentyp 21 ein Standardtyp mit standardisierten Eigenschaften beispielsweise hinsichtlich Körpergröße, Geschlecht, Gewicht und Ethnie gewählt wird oder ob für den jeweiligen Fahrzeuginsassen 8 ein individueller Typ mit individuellen Eigenschaften beispielsweise hinsichtlich Körpergröße, Geschlecht, Gewicht und Ethnie gewählt wird. Darüber hinaus erfolgt auch eine Anpassung 22 des Äu-ßeren der jeweiligen Fahrzeuginsassen 8, wie beispielsweise hinsichtlich deren Aussehen, Kleidung, Kopfbedeckung, Haarfarbe, Frisur etc.

Weiterhin werden bei der Auswahl des virtuellen Innenraums des Fahrzeugs 7 im Rahmen des Innenraummodells 14 der Simulationsumgebung 1 auch verhaltensbezogene Parameter 16 der jeweiligen Fahrzeuginsassen 8 ausgewählt beziehungsweise variabel vorgegeben, insbesondere abhängig von der ausgewählten zu überprüfenden Fahrzeugfunktion 5 und dem hierzu vorgegebenen Anwendungsfall 6. Hierbei werden die Posen 23 und die Animationen der jeweiligen Fahrzeuginsassen 8 pro Zeit gewählt, das heißt die Haltungen der jeweiligen Fahrzeuginsassen 8, die jeder der jeweiligen Fahrzeuginsassen 8 während des Testfalls 3 einnehmen soll. Weiterhin werden auch die Handlungen und Aktionen 24 der jeweiligen Fahrzeuginsassen 8 pro Zeit gewählt, wie das Umschauen oder das Anlehnen der jeweiligen Fahrzeuginsassen 8, die jeder der jeweiligen Fahrzeuginsassen 8 während des Testfalls 3 durchführen beziehungsweise vornehmen soll. Hierzu werden insbesondere auch Gutfälle und Schlechtfälle definiert und diese als Grenzfälle für Testfälle 3 im Grenzbereich zwischen Gutfällen und Schlechtfällen abgeprüft. Die jeweiligen Posen 23 und Animationen der jeweiligen Fahrzeuginsassen 8 sowie die Handlungen und Aktionen 24 der jeweiligen Fahrzeuginsassen 8, können hierbei frei erstellt werden und insbesondere auch durch Aufnahme von echten Menschen im Rahmen des sogenannten motion capturing generiert werden.

Zudem werden bei der Auswahl des virtuellen Innenraums des Fahrzeugs 7 im Rahmen des Innenraummodells 14 der Simulationsumgebung 1 auch sensorbezogene Parameter 17 ausgewählt beziehungsweise variabel vorgegeben, insbesondere abhängig von dem ausgewählten zu überprüfenden Fahrzeugsystem als Fahrzeugfunktion 5 und dem hierzu vorgegebenen Anwendungsfall 6. Hierbei erfolgt zunächst eine Auswahl 25, 26 der relevanten Sensoren 9 oder Sensorsysteme, das heißt welche Art von Sensoren 9 und welcher Sensortyp herangezogen werden soll. Beispielsweise können hier mechanische Sensoren 26 wie Sitzbelegungssensoren oder Gurtauszugssensoren oder bildgebende Sensoren 25 wie optische Sensoren (Kameras) oder Radarsensoren oder Ultraschallsensoren herangezogen werden. Weiterhin wird die Anordnung 27 und auch die Anzahl der jeweiligen Sensoren 9 oder Sensorsysteme und damit deren Platzierung im Innenraum des Fahrzeugs 7 gewählt und vorgegeben. Dies ist insbesondere abhängig davon, welche und wie viele der Fahrzeuginsassen 8 von den Sensoren 9 oder Sensorsystemen beobachtet werden sollen. Schließlich erfolgt eine Anpassung und Konfiguration 28 der Sensoren 9 oder Sensorsysteme hinsichtlich deren intrinsischen Eigenschaften, wie beispielsweise des Abbildungsverhaltens oder des Rauschverhaltens der Sensoren 9 oder der Sensorsysteme. Hierdurch soll insbesondere gewährleistet werden, dass die Eigenschaften der Sensoren 9 oder der Sensorsysteme den Eigenschaften von realen Sensoren 9 oder Sensorsystemen entsprechen.

Nachdem hiermit die vorbereitenden Maßnahmen für den jeweiligen Testfall 3 abgeschlossen sind, wird für diesen Testfall 3 eine Simulation 2 durchgeführt. Hierbei können die jeweiligen Testfälle 3 anhand einer Testfallliste 32 ausgewählt werden. Insbesondere kann auch ein Testfallautomatismus 31 implementiert werden, durch den eine Sequenz von aufeinanderfolgenden Testfällen 3 sukzessive für die Simulation 2 automatisiert vorgegeben wird.

Die Simulation 2 mit dem zeitlich genau auf die jeweiligen Fahrzeuginsassen 8 getakteten Ablauf des jeweiligen Testfalls 3, kann dabei in Echtzeit oder schneller als in Echtzeit erfolgen und damit quasi live in einem "Hardware in the loop" Konzept (HIL) mit Bezug auf (reale) Hardwarekomponenten des Fahrzeugs 7 oder in einem "Software in the loop" Konzept (SIL) ohne Bezug auf (reale) Hardwarekomponenten des Fahrzeugs 7 vorgenommen werden. Da beim "Software in the loop" Konzept keine Bindung an Hardwarekomponenten des Fahrzeugs 7 und deren zeitliche Ablauftaktung vorhanden ist, kann dieses Konzept sehr schnell ausgeführt werden, und insbesondere auch in Echtzeit oder oftmals auch schneller als in Echtzeit ausgeführt werden.

Hierbei kann durch die Simulation 2 mit der Ausführung des jeweiligen Testfalls 3 eine geschlossene Wirkungskette realisiert werden ("closed loop"), bei der die Simulation 2 und das Simulationsergebnis Rückwirkungen auf das Verhalten des Fahrzeugs 7 mit sich bringt oder bewirkt, beispielsweise einen Bremsvorgang des Fahrzeugs 7 bewirkt, was dann wiederum Auswirkungen auf die Simulation 2 hervorruft usw.. Alternativ hierzu kann durch die Simulation 2 mit der Ausführung des jeweiligen Testfalls 3 eine offene Wirkungskette realisiert werden ("open loop"), bei der die Simulation 2 lediglich Videoströme und/oder Datenströme generiert und das Simulationsergebnis (zunächst) keine direkten Rückwirkungen auf das Verhalten des Fahrzeugs 7 mit sich bringt oder bewirkt.

Bei einem hierzu exemplarisch angeführten ersten Ausführungsbeispiel wird eine Simulation 2 in Zusammenhang mit einer bestimmten Absicherungsfunktion 53 als Fahrzeugfunktion 5 durchgeführt. Im Rahmen eines Anwendungsfalls 6 soll für crashrelevante Sachverhalte des Fahrzeugs 7 eine Absicherung 62 dahingehend erfolgen und damit detektiert werden, ob die Fahrzeuginsassen 8 des Fahrzeugs 7 ihre Füße auf dem Boden des Fahrzeugs 7 haben und dass sich die Füße der Fahrzeuginsassen 8 auch korrekt auf dem Boden des Fahrzeugs 7 befinden. Die Auswahl der Simulationsumgebung 1 mit den jeweiligen Simulationsmodellen 11, 12. 13, 14 und der Ablaufder Simulation 2 erfolgt wie anhand der Figur 1 und der Figur 2 beschrieben. Die Ausführung der insbesondere in einem Grenzbereich zwischen Gutfällen und Schlechtfällen liegenden Testfälle 3 kann entweder in Echtzeit erfolgen, das heißt sozusagen "live" in entsprechend ausgewählten Hardwarekomponenten des Fahrzeugs 7, oder es können entsprechend der Simulation 2 Videoströme und Datenströme generiert werden. Nach der Verknüpfung des Fahrzeugs 7 mit der Umwelt, insbesondere durch Erfassung der Fahrtrajektorie des Fahrzeugs durch Erzeugung sogenannter "Groundtruth Daten", die für jeden Zeitpunkt angeben und aufzeichnen, wo das Fahrzeug 7 fährt, beispielsweise auf welcher Straßenkategorie, und wie das Fahrzeug 7 fährt, beispielsweise mit welcher Geschwindigkeit, werden die Simulationsergebnisse der Simulation 2 angezeigt. Hierbei werden die erzeugten und abgespeicherten "Groundtruth Daten" mit den von den simulierten Sensoren 9 stammenden Videoströmen und/oder Datenströmen verglichen. Anhand dieses Vergleichs erfolgt dann eine Auswertung, deren Ergebnis auf geeignete Weise visualisiert werden kann.

Bei einem hierzu exemplarisch angeführten zweiten Ausführungsbeispiel wird eine Simulation 2 in Zusammenhang mit einer bestimmten Positionierungsaufgabe durchgeführt. Im Rahmen eines Anwendungsfalls 6 soll für einen bildgebenden Sensor 25 und in Abhängigkeit von dessen Funktionalität im Rahmen der Entwicklung 63 des Sensors 25, eine optimale Position beziehungsweise eine optimierte Position im Innenraum des Fahrzeugs 7 gefunden werden. Dies soll beispielsweise insbesondere dahingehend erfolgen, ob der Sichtbereich des bildgebenden Sensors 25 zur Detektion von Fahrzeuginsassen 8 oder von Gegenständen im Innenraum des Fahrzeugs 7 unter Berücksichtigung von möglichen Bewegungen der Fahrzeuginsassen 8 des Fahrzeugs 7 ausreichend ist. Die Auswahl der Simulationsumgebung 1 mir den jeweiligen Simulationsmodellen 11, 12. 13, 14 und der Ablauf der Simulation 2 erfolgt wie anhand der Figur 1 und der Figur 2 beschrieben. Hierbei kann die Sensorposition 27 des bildgebenden Sensors 25 im Innenraum des Fahrzeugs 7 im Rahmen der Auswahl der Simulationsumgebung 1 in Echtzeit angepasst werden. Nach Auswahl der jeweiligen Sensorposition 27 des bildgebenden Sensors 25 werden verschiedene Testfälle 3 im Rahmen einer Simulation 2 ausgeführt. Hierbei werden insbesondere eine Vielzahl von Grenzfällen als Testfälle 3 im Grenzbereich zwischen Gutfällen und Schlechtfällen ausgeführt, wobei bei den Gutfällen durch die gewählte Sensorposition 27 des bildgebenden Sensors 25 eine (noch) ausreichende Sicht auf den Innenraum des Fahrzeugs 7 und auf die Fahrzeuginsassen 8 vorhanden ist und bei den Schlechtfällen durch die gewählte Sensorposition 27 des bildgebenden Sensors 25 keine Sicht mehr auf den Innenraum des Fahrzeugs 7 und auf die Fahrzeuginsassen 8 vorhanden ist oder keine ausreichende Sicht mehr auf den Innenraum des Fahrzeugs 7 und auf die Fahrzeuginsassen 8 vorhanden ist. Die Simulation 2 des jeweiligen Testfalls 3 kann auch hier in Echtzeit (live) anhand der Generierung von Videoströmen und/oder Datenströmen erfolgen. Zur Auswertung und Bewertung der Simulation 2 können von den jeweiligen Sensorpositionen 27 des bildgebenden Sensors 25 und den Verhältnissen im Innenraum des Fahrzeugs 7 Momentaufnahmen gefertigt werden und hierdurch die Simulationsergebnisse visualisiert werden. Anhand der Simulationsergebnisse kann dann eine optimale Sensorposition 27 des bildgebenden Sensors 25 im Innenraum des Fahrzeugs 7 gefunden werden beziehungsweise eine Sensorposition 27 des bildgebenden Sensors 25 im Innenraum des Fahrzeugs 7 als Kompromiss für unterschiedlichen Randbedingungen hinsichtlich der Positionierung des bildgebenden Sensors 25 ausgewählt werden.

### BEZUGSZEICHENLISTE:

- 1: Simulationsumgebung
- 2: Simulation
- 3: Testfälle
- 4: Ausgabe Ergebnisse
- 5: Fahrzeugfunktionen, insbesondere Fahrzeugsysteme
- 6: Anwendungsfälle
- 7: Fahrzeug
- 8: Fahrzeuginsassen
- 9: Sensoren
- 10: Konfiguration Simulation
- 11: Umfeldmodell
- 12: Fahrzeugmodell
- 13: Fahrermodell
- 14: Innenraummodell
- 15: Insassenbezogene Parameter Innenraummodell
- 16: Verhaltensbezogene Parameter Innenraummodell
- 17: Sensorbezogene Parameter Innenraummodell
- 18: Auswahl Fahrzeug
- 19: Anpassung Fahrzeug
- 20: Konfiguration Sitze
- 21: Auswahl Insassentyp
- 22: Anpassung Insasse
- 23: Posen
- 24: Animation
- 25: bildgebende Sensoren
- 26: sonstige Sensoren
- 27: Anordnung / Positionierung Sensoren
- 28: Anpassung Sensoren
- 31: Testfallautomatismus
- 32: Testfallliste
- 51: Funktion Fahrerbeobachtung
- 52: Funktion Innenraumbeobachtung
- 53: Funktion Innenraum Absicherung
- 61: Anwendungsfall Verhinderung / Warnung
- 62: Anwendungsfall Absicherung
- 63: Anwendungsfall Entwicklung / Optimierung / Test
- 64: Anwendungsfall Fahrersichtbereich / Fahrzeuginsassensichtbereich

## Patentansprüche

1. Verfahren zur Überprüfung von Fahrzeugfunktionen (5) für den Innenraum eines Fahrzeugs (7), wobei die Fahrzeugfunktionen (5) Sensordaten mindestens eines im Innenraum des Fahrzeugs (7) angeordneten Sensors (9) verarbeiten,
**dadurch gekennzeichnet,**
**dass** die Sensordaten des mindestens einen im Innenraum des Fahrzeugs (7) angeordneten Sensors (9) durch Simulation (2) des mindestens einen Sensors (9) unter Verwendung eines Umfeldmodells (11) zur virtuellen Typisierung des Außenbereichs des Fahrzeugs (7), eines Fahrzeugmodells (12) zur virtuellen Typisierung des Fahrzeugs (7), und eines Innenraummodells (14) zur virtuellen Typisierung des Innenbereichs des Fahrzeugs (7) generiert werden.

2. Verfahren nach Anspruch 1,
**dadurch gekennzeichnet,**
**dass** für das Innenraummodell (14) zur virtuellen Typisierung des Innenbereichs des Fahrzeugs (7) insassenbezogene Parameter (15) für mindestens einen Fahrzeuginsassen (8) und handlungsbezogene Parameter (16) für mindestens einen Fahrzeuginsassen (8) und/oder sensorbezogene Parameter (17) für mindestens einen Sensor (9) im Innenraum des Fahrzeugs (7) herangezogen werden.

3. Verfahren nach Anspruch 2,
**dadurch gekennzeichnet,**
**dass** als insassenbezogene Parameter (15) des Innenraummodells (14) die den jeweiligen Fahrzeuginsassen (8) zugeordneten Fahrzeugsitze (20) charakterisierende Kenngrößen und/oder den Insassentyp (21) der jeweiligen Fahrzeuginsassen (8) charakterisierende Kenngrößen und/oder die Ausstattung (22) der jeweiligen Fahrzeuginsassen (8) charakterisierende Kenngrößen herangezogen werden.

4. Verfahren nach Anspruch 2 oder 3,
**dadurch gekennzeichnet,**
**dass** als handlungsbezogene Parameter (16) des Innenraummodells (14) die Körperhaltung (23) der jeweiligen Fahrzeuginsassen (8) charakterisierende Kenngrößen und/oder Aktionen (24) der jeweiligen Fahrzeuginsassen (8) charakterisierende Kenngrößen herangezogen werden.

5. Verfahren nach einem der Ansprüche 2 bis 4,
**dadurch gekennzeichnet,**
**dass** als sensorbezogene Parameter (17) des Innenraummodells (14) die Art (25, 26) des jeweiligen Sensors (9) und/oder die Anordnung (27) des jeweiligen Sensors (9) im Innenraum des Fahrzeugs (7) und/oder die intrinsischen Eigenschaften (28) des jeweiligen Sensors (9) herangezogen werden.

6. Verfahren nach einem der Ansprüche 2 bis 5,
**dadurch gekennzeichnet,**
**dass** die insassenbezogenen Parameter (15) des Innenraummodells (14) und/oder die handlungsbezogenen Parameter (16) des Innenraummodells (14) und/oder die sensorbezogenen Parameter (17) des Innenraummodells (14) in Abhängigkeit der zu simulierenden Sensoren (9) unterschiedlich und an die zu überprüfende Fahrzeugfunktion (5) und/oder an den jeweiligen Anwendungsfall (6) angepasst gewählt werden.

7. Verfahren nach einem der Ansprüche 2 bis 6,
**dadurch gekennzeichnet,**
**dass** für die zu überprüfende Fahrzeugfunktion (5) eine Anzahl von Testfällen (3) vorgegeben wird, bei denen eine Simulation (2) des mindestens eines im Innenraum des Fahrzeugs (7) angeordneten Sensors (9) mit jeweils unterschiedlichen Werten für die insassenbezogenen Parameter (15) des Innenraummodells (14) und/oder für die handlungsbezogenen Parameter (16) des Innenraummodells (14) und/oder für die sensorbezogenen Parameter (17) des Innenraummodells (14) durchgeführt wird.

8. Verfahren nach Anspruch 7, **dadurch gekennzeichnet,**
**dass** für die zu überprüfende Fahrzeugfunktion (5) als Testfälle (3) Gutfälle und Schlechtfälle definiert werden,
und **dass** die Simulation (2) des mindestens eines im Innenraum des Fahrzeugs (7) angeordneten Sensors (9) für eine Vielzahl von Testfällen (3) als Grenzfälle im Grenzbereich zwischen Gutfällen und Schlechtfällen durchgeführt wird.

9. Verfahren nach einem der Ansprüche 1 bis 8,
**dadurch gekennzeichnet,**
**dass** bei der Simulation (2) des mindestens eines im Innenraum des Fahrzeugs (7) angeordneten Sensors (9) die Vorgabewerte eines Fahrermodells (13) mit der virtuellen Typisierung des Fahrers des Fahrzeugs (7) berücksichtigt werden.

10. Verfahren nach einem der Ansprüche 1 bis 9,
**dadurch gekennzeichnet,**
**dass** die Sensordaten mehrerer im Innenraum des Fahrzeugs (7) angeordneten Sensoren (9) durch simultane Simulation (2) in Echtzeit generiert werden.
